**Europäisches Patentamt**

**European Patent Office**

**Office européen des brevets**

(19)

(11) Veröffentlichungsnummer : **0 028 798**
**B1**

(12) **EUROPÄISCHE PATENTSCHRIFT**

(45) Veröffentlichungstag der Patentschrift :
08.02.84

(21) Anmeldenummer : 80106776.0

(22) Anmeldetag : 04.11.80

(51) Int. Cl.³ : **H 01 L 29/74**, H 01 L 29/743,
H 01 L 29/08, H 01 L 29/52

(54) **Thyristor mit Hilfsemitterelektrode und Verfahren zu seinem Betrieb.**

(30) Priorität : 09.11.79 DE 2945347

(43) Veröffentlichungstag der Anmeldung :
20.05.81 Patentblatt 81/20

(45) Bekanntmachung des Hinweises auf die Patenterteilung : 08.02.84 Patentblatt 84/06

(84) Benannte Vertragsstaaten :
**FR GB IT SE**

(56) Entgegenhaltungen :
DE-A- 2 625 917
FR-A- 1 362 724

(73) Patentinhaber : SIEMENS AKTIENGESELLSCHAFT
Berlin und München Wittelsbacherplatz 2
D-8000 München 2 (DE)

(72) Erfinder : Patalong, Hubert, Dr.
Kurt-Floericke-Strasse 18
D-8000 München 60 (DE)

EP 0 028 798 B1

Thyristor mit Hilfsemitterelektrode und Verfahren zu seinem Betrieb

Die Erfindung bezieht sich auf einen Thyristor mit einer Hilfsemitterelektrode nach dem Oberbegriff des Anspruchs 1 und auf Verfahren zu seinem Betrieb.

Die aus dem Buch von E. Spenke « pn-Übergänge » (Band 5 der Reihe « Halbleiter-Elektronik »), Springer-Verlag, Berlin 1979, Seiten 123 und 124, insbesondere Abb. 16. 15, bekannten Thyristoren dieser Art sind für große Anstiegsgeschwindigkeiten des zwischen Anode und Kathode fließenden Laststroms geeignet, da ihre innere Zündverstärkung einen sehr schnellen Ablauf des ganzen Zündvorgangs gewährleistet. Aus der DE-A-2 625 917 ist ein Thyristor bekannt, bei dem zur Unterdruckung der Zündung durch ein äußeres Signal an der die Emitterelektrode tragenden Grenzfläche des Halbleiterkörpers ein als MIS-Struktur ausgebildeter, abschaltbarer strompfad angeordnet ist.

Der Erfindung liegt die Aufgabe zugrunde, einen solchen Thyristor mit möglichst einfachen Schaltungsmaßnahmen in seiner Stabilität zu verbessern, d. h. eine große Sicherheit gegen unbeabsichtigte Zündvorgänge beim Auftreten von in Durchlaßrichtung gepolten Spannungen an der Anoden-Kathoden-Strecke zu erreichen, ohne hierdurch sein Einschaltverhalten zu beeinträchtigen. Diese Aufgabe wird erfindungsgemäß durch die im Anspruch 1 gekennzeichneten Merkmale gelöst.

Aus der US-A-3 243 669 ist ein Thyristor mit steuerbaren Emitter-Kurzschlüssen bekannt, die als MIS-Strukturen ausgebildet sind. Beim Anlegen einer Steuerspannung an das Gate einer MIS-Struktur wird hierbei ein Kurzschlußpfad wirksam geschaltet, der den PN-Übergang zwischen der mit der Kathode (Anode) verbundenen Emitterschicht und der angrenzenden Basisschicht überbrückt. Das hat eine Umschaltung des Thyristors aus dem stromführenden Zustand in den blockierten Zustand zur Folge, in dem zwischen Kathode und Anode trotz einer in Durchlaßrichtung anliegenden Spannung praktisch kein Strom fließt. Die Umschaltung aus dem blockierten Zustand in den stromführenden Zustand erfolgt durch das Anlegen einer weiteren Steuerspannung an das Gate einer weiteren MIS-Struktur, die einen PN-Übergang zwischen zwei inneren Halbleiterschichten des Thyristors überbrückt. Der Betrieb des Thyristors mit zwei Steuerspannungen erfordert jedoch einen entsprechenden Schaltungsaufwand.

Andererseits ist beispielsweise aus der DE-B-24 38 894 ein Thyristor mit einem Kurzschlußemitter bekannt, bei dem eine außenliegende Emitterzone von mehreren, als Teile der angrenzenden Basisschicht aufzufassenden Kurzschlußzonen durchdrungen wird, die sich bis zur Grenzfläche des Thyristorkörpers erstrecken und in dieser mit der Kathode verbunden sind. Nachteilig ist hierbei, daß viele Kurzschlußzonen vorgesehen werden müssen, um eine gute Stabilität des Thyristors zu erreichen. Mit steigender Anzahl der Kurzschlußzonen verschlechtert sich jedoch das Zündverhalten des Thyristors immer mehr. Die gezündete Fläche breitet sich in lateraler Richtung immer langsamer über den gesamten Querschnitt aus. Als Folge hiervon entstehen erhebliche Einschaltverluste.

Der erfindungsgemäß ausgebildete Thyristor zeichnet sich dadurch aus, daß der Hauptemitter mit technologisch weniger aufwendigen Kurzschlußzonen durchsetzt ist und lediglich die Hilfsemitterzone mit den steuerbaren Kurzschlußstrukturen ausgestattet ist, die aber gerade an dieser Stelle die Zündbereitschaft des Thyristors entscheidend beeinflussen, so daß schnelle Zündvorgänge und geringe Einschaltverluste erreicht werden.

Die Ansprüche 2 bis 5 sind auf vorteilhafte Weiterbildungen und Ausgestaltungen der Erfindung gerichtet, während die Ansprüche 6 und 7 vorteilhafte Verfahren zum Betrieb erfindungsgemäßer Thyristoren betreffen.

Die Erfindung wird nachfolgend anhand der Zeichnung näher erläutert. Dabei zeigt :

Figur 1 den Querschnitt eines ersten Ausführungsbeispiels der Erfindung,

Figur 2 eine Draufsicht der Anordnung nach Fig. 1 und

Figur 3 den Querschnitt eines zweiten Ausführungsbeispiels.

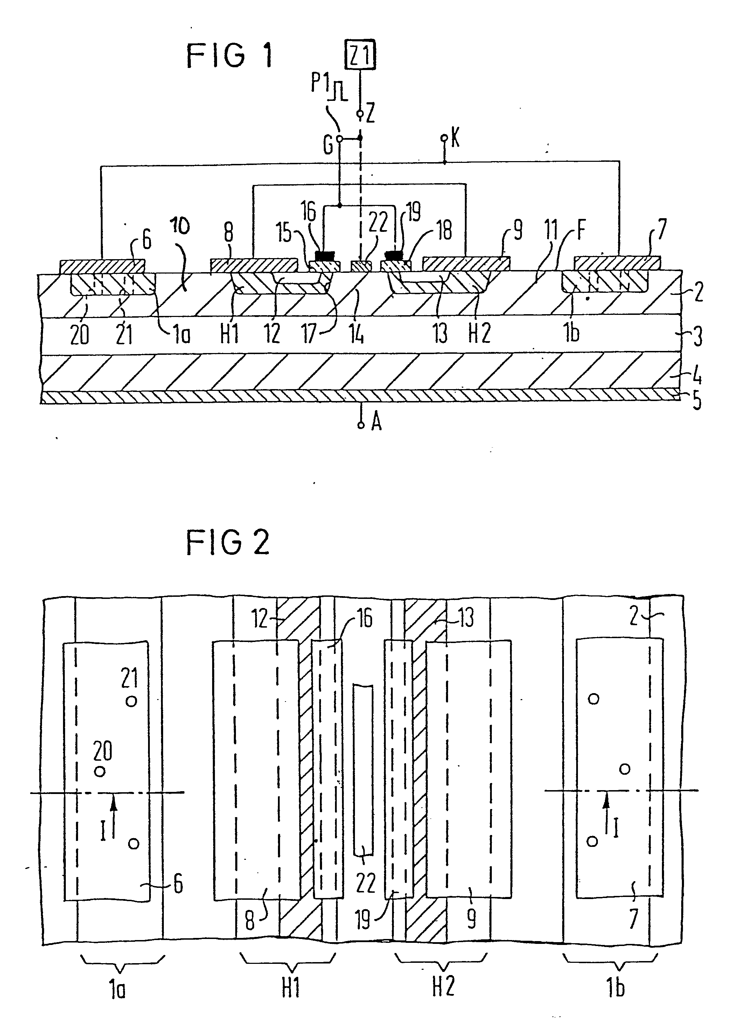

Der in Fig. 1 und Fig. 2 dargestellte Thyristor weist einen Halbleiterkörper mit Halbleiterschichten 1 bis 4 unterschiedlicher Leitfähigkeitstypen auf, die beispielsweise aus dotiertem Silizium bestehen. Dabei werden die außen liegende N-leitende Schicht 1, die in zwei Teilschichten 1a und 1b aufgeteilt ist, als erste, N-Emitterschicht und die außen liegende P-leitende Schicht 4 als zweite, P-Emitterschicht bezeichnet. Die P-leitende Schicht 2 und die N-leitende Schicht 3 stellen die sogenannten Basisschichten dar. Die P-Emitterschicht 4 ist mit einer zweiten Elektrode als Anode 5 versehen, die einen Anodenanschluß A besitzt. Die Teilschichten 1a und 1b der N-Emitterschicht sind in Fig. 2 als vertikal verlaufende, parallele Streifen erkennbar. Jede der Teilschichten 1a und 1b ist mit einem Teil 6 bzw. 7 einer ersten Elektrode in Form einer Kathode versehen, wobei die Teile 6, 7 untereinander leitend verbunden und an einen gemeinsamen Kathodenanschluß K geführt sind.

In der Fig. 1, die einen Querschnitt längs der Linie I-I von Fig. 2 zeigt, ist eine außen liegende N-leitende Hilfsemitterzone erkennbar, die aus den Teilzonen H1 und H2 besteht. Letztere sind jeweils mit einem Teil 8 bzw. 9 einer Hilfsemitterelektrode versehen, wobei die Teile 8 und 9 leitend miteinander verbunden sind. Auf den den N-Emitter-Teilschichten 1a und 1b zugewandten Seiten sind die Teile 8 und 9 derart verlängert, daß sie die dort befindlichen PN-Übergänge zwischen den Hilfsemitter-Teilzonen und den mit 10 und 11 bezeichneten Teilen der Basisschicht 2 überbrücken. In die Hilfsemitter-Teilzonen H1 und H2 sind P-leitende zweite Halbleitergebiete 12 und 13 so eingefügt, daß sie sich bis zur ersten Grenzfläche F des Halbleiterkörpers erstrecken. In Fig. 2 sind die Oberflächen dieser Halbleitergebiete der besseren Übersichtlichkeit wegen schraffiert. Die Gebiete 12 und 13 werden jeweils randseitig von den Teilen 8, 9 der Hilfsemitterelektrode kontaktiert. Mit 14 ist eine Zone der Basisschicht 2 bezeichnet, die bis zur ersten Grenzfläche F reicht und die Teilzonen H1 und H2 voneinander trennt. Die Zone 14 bildet dabei ein erstes P-leitendes Halbleitergebiet, das Halbleitergebiet 12 ein zweites P-leitendes Halbleitergebiet und der dazwischenliegende Teil der Teilzone H1 eine N-leitende Zwischenschicht. Auf der ersten Grenzfläche F ist eine dünne, elektrisch isolierende Schicht 15, z. B. aus $SiO_2$, vorgesehen, auf der ein Gate 16 so angeordnet ist, daß es die N-Zwischenschicht überdeckt. Die Teile 12, H1, 14, 15 und 16 bilden eine MIS-Struktur. Gehört sie dem Verarmungstyp an, so befindet sich ohne Einwirkung einer Spannung auf das Gate 16 ein P-leitender Inversionskanal 17 an der Grenzfläche F zwischen den Gebieten 12 und 14, der diese miteinander leitend verbindet. Legt man eine positive Steuerspannung an einen Steuerspannungsanschluß G des Gate 16, so wird der Inversionskanal 17 beseitigt. Ist die MIS-Struktur vom Anreicherungstyp, so besteht bei spannungslosem Gate 16 kein Inversionskanal 17. Dieser wird erst durch das Anlegen einer negativen Steuerspannung an G durch Inversion der Teilzone H1 unterhalb des Gate 16 aufgebaut.

Der Inversionskanal 15 stellt also einen steuerbaren Hilfsemitter-Kurzschluß dar, der die Basisschicht 2 mit dem Gebiet 12 und damit mit dem Teil 8 der Hilfsemitterelektrode in Abhängigkeit von einer dem Anschluß G zugeführten Steuerspannung wahlweise niederohmig verbindet.

Durch die Anordnung einer elektrisch isolierenden Schicht 18, z. B. aus $SiO_2$, auf der ein ebenfalls mit G verbundenes Gate 19 vorgesehen ist, ergibt sich in analoger Weise eine MIS-Struktur 13, H2, 14, 18 und 19, in der in Abhängigkeit von der bei G anliegenden Steuerspannung ein Emitter-Kurzschluß zwischen den Gebieten 13 und 14 und damit zwischen der Basisschicht 2 und dem Teil 9 der Hilfsemitterelektrode wirksam geschaltet wird oder nicht.

Die N-Emitter-Teilschicht 1a ist von Zonen 20, 21 der Basisschicht 2 durchdrungen, die sich bis zur ersten Grenzfläche F des Halbleiterkörpers erstrecken und in dieser jeweils mit dem Teil 6 der Kathode leitend verbunden sind. Hierbei handelt es sich um nicht steuerbare Emitter-Kurzschlüsse. Solche finden sich auch in der N-Emitter-Teilschicht 1b.

Bei MIS-Strukturen des Verarmungstyps sind die Emitter Kurzschlüsse bei spannungslosem Anschluß G jeweils wirksam. Dabei befindet sich der Thyristor im blockierten Zustand, in dem trotz einer in Durchlaßrichtung gepolten Spannung an den Anschlüssen A und K zwischen den letzteren praktisch kein Strom fließt. Die thermisch generierten Defektelektronen werden aus der Basisschicht 2 zu den Teilen 8 und 9 der Hilfsemitterelektrode abgeleitet, so daß aus den Hilfsemitter-Teilzonen H1 und H2 keine Ladungsträger in die Basisschicht 2 injiziert werden. Daher entsteht kein Hilfsstrom zwischen der P-Emitterschicht 4 und den Hilfsemitter-Teilzonen, der über die Teile 8 und 9 zu den N-Emitter-Teilschichten 6 und 7 hingeleitet werden könnte, um den Thyristor vollständig zu zünden. Es besteht also ein Zustand geringer Zündempfindlichkeit bzw. hoher Stabilität. Erst bei Zuführung eines positiven Spannungsimpulses P1 an G werden die Emitter-Kurzschlüsse nur für die Dauer von P1 abgeschaltet, wobei sich zunächst ein Hilfsstrom über die Hilfsemitter-Teilzonen aufbaut, der den Thyristor dann zündet, so daß er in den stromführenden Zustand gelangt. Danach fließt ein Laststrom eines an A und K angeschlossenen Lastkreises über den gesamten niederohmig geschalteten Thyristor. Die Abschaltung des letzteren wird durch eine Abschaltung der zwischen A und K in Durchlaßrichtung anliegenden Spannung erreicht, oder, falls es sich bei ihr um eine Wechselspannung handelt, durch den nächstfolgenden Nulldurchgang. Für die beschriebene Umschaltung des Thyristors genügt im Prinzip auch eine der beiden in Fig. 1 dargestellten MIS-Strukturen.

Der Ablauf des Zündvorgangs kann noch beschleunigt werden, wenn die Basisschicht 2 mit einer Zündelektrode versehen wird. In Fig. 1 kontaktiert die mit 22 bezeichnete Zündelektrode die Zone 14. Die Zündelektrode ist mit einem Anschluß Z für einen Zündstromkreis Z1 versehen, der einen Zündstrom in die Basisschicht 2 einspeist. Nach einer Weiterbildung der Erfindung wird der Anschluß G mit dem Anschluß Z verbunden, wie gestrichelt dargestellt ist. In diesem Fall wird ein an Z abgreifbarer Zündspannungsimpuls als Impuls P1 verwendet.

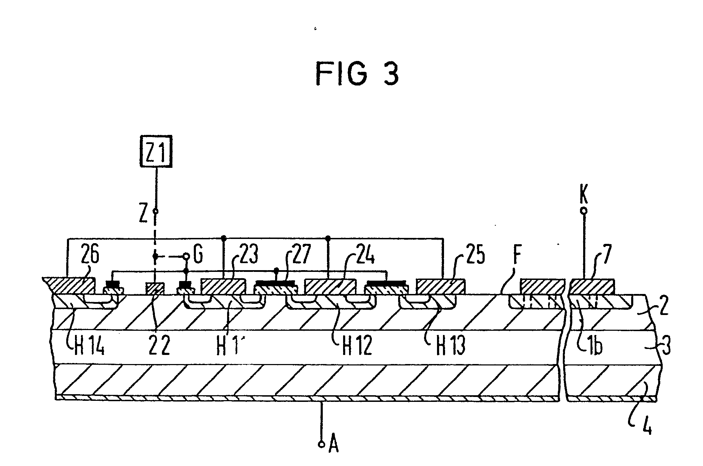

Fig. 3 zeigt einen Thyristor der bereits beschriebenen Art, bei dem mehrere Hilfsemitter-Teilzonen H11 bis H14 vorgesehen sind, die mit Teilen 23 bis 26 einer Hilfsemitterelektrode versehen sind. Hierbei sind zur Steuerung zweier benachbarter MIS-Strukturen jeweils gemeinsame Gates vorgesehen, z. B. das Gate 27, die mit dem Anschluß G verbunden sind. Der Thyristor ist im Bereich der N-Emitter-Teilschicht 1b unterbrochen, da dieser Bereich wesentlich größer ist als der die Hilfsemitter-Teilzonen aufweisende Halbleiterbereich. Für die Länge der einzelnen Inversionskanäle 17 kommen beispielsweise zwei bis drei µm in Betracht. Die Teile 23 bis 27, H11 bis H14, 1b und 7 können beispielsweise streifenförmig ausgebildet sein und wie die entsprechenden Teile in Fig. 2 im wesentlichen parallel zueinander verlaufen. Andererseits kann der Thyristor nach Fig. 3 auch als ein rotationssymmetrischer Körper mit einer durch die Elektrode 22 gehenden Symmetrieachse aufgefaßt werden, wobei dann die an der Fläche F vorgesehenen Strukturen ringförmig ausgebildet sind.

## Ansprüche

1. Thyristor mit einem Halbleiterkörper, der eine außen liegende, mit einer ersten Elektrode (6, 7) versehene erste Emitterschicht (1a, 1b), eine außen liegende, mit einer zweiten Elektrode (5) versehene zweite Emitterschicht (4), zwei an diese jeweils angrenzende Basisschichten (2, 3) und eine außen liegende Hilfsemitterzone (H1, H2 ; H11-H14) enthält, die an eine der Basisschichten (2) angrenzt und mit einer Hilfsemitterelektrode (8, 9 ; 23-26) versehen ist, die auf der der ersten Emitterschicht zugewandten Seite derart verlängert ist, daß sie einen dort befindlichen PN-Übergang zwischen der Hilfsemitterzone und einem Teil der angrenzenden Basisschicht überbrückt, dadurch gekennzeichnet, daß an der die Hilfsemitterelektrode (8, 9) tragenden ersten Grenzfläche (F) des Halbleiterkörpers wenigstens ein als eine MIS-Struktur (12, H1, 14, 15, 16) ausgebildeter, abschaltbarer Strompfad angeordnet ist, der ein mit der an der ersten Grenzfläche (F) liegenden Basisschicht (2) zusammenhängendes erstes Halbleitergebiet (14), ein innerhalb der Hilfsemitterzone (H1, H2 ; H11-H14) angeordnetes zweites Halbleitergebiet (12) des gleichen Leitfähigkeitstyps wie das erste Halbleitergebiet und eine zwischen diesen zwei Halbleitergebieten liegende mit der Hilfsemitterzone zusammenhängende Zwischenschicht des entgegengesetzten Leitfähigkeitstyps umfaßt, die von einem gegenüber dem Halbleiterkörper elektrisch isolierten, mit einem Steuerspannungsanschluß (G) versehenen Gate (16, 19) überdeckt ist, und daß die erste Emitterschicht (1a, 1b) von wenigstens einer Zone (20, 21) der angrenzenden Basisschicht (2) durchdrungen wird, die sich bis zur ersten Grenzfläche (F) des Halbleiterkörpers erstreckt und in dieser mit der ersten Elektrode (6, 7) leitend verbunden ist.

2. Thyristor nach Anspruch 1, dadurch gekennzeichnet, daß die Hilfsemitterzone in eine Mehrzahl von Teilzonen (H11 bis H14) aufgeteilt ist, die jeweils mit untereinander leitend verbundenen Teilen (23 bis 26) der Hilfsemitterelektrode versehen sind, und daß eine Mehrzahl von streifenförmigen MIS-Strukturen vorgesehen sind, die randseitig zu den Teilzonen (H11 bis H14) angeordnet sind.

3. Thyristor nach einem der Ansprüche 1 oder 2, dadurch gekennzeichnet, daß die ersten Halbleitergebiete (12, 13) der MIS-Strukturen jeweils derart in die Hilfsemitterzone bzw. in deren Teilzonen (H1, H2) eingefügt sind, daß sie sich bis zur ersten Grenzfläche (F) des Halbleiterkörpers erstrecken, in der sie mit der Hilfsemitterelektrode, bzw. mit deren Teilen (8, 9) leitend verbunden sind, daß die zweiten Halbleitergebiete der MIS-Strukturen jeweils aus Teilen (14) der an die Hilfsemitterzone (H1, H2) angrenzenden Basisschicht (2) bestehen, die sich bis an die Grenzfläche (F) erstrecken und daß die Zwischenschichten jeweils aus den Teilen der Hilfsemitterzone bzw. deren Teilzonen (H1, H2) bestehen, die sich zwischen den einander gegenüberliegenden Grenzflächen der Teile (14) der angrenzenden Basisschicht (2) und der ersten Halbleitergebiete (12, 13) befinden.

4. Thyristor nach einem der vorhergehenden Ansprüche, dadurch gekennzeichnet, daß eine Basisschicht oder eine Zone derselben mit einer Zündelektrode (22) versehen ist, die einen Anschluß (Z) für einen Zündstromkreis (Z1) aufweist.

5. Thyristor nach Anspruch 4, dadurch gekennzeichnet, daß der Anschluß (Z) für den Zündstromkreis mit dem Steuerspannungsanschluß (G) der MIS-Strukturen verbunden ist.

6. Verfahren zum Betrieb eines Thyristors nach Anspruch 1, dadurch gekennzeichnet, daß dem Steuerspannungsanschluß (G) der MIS-Strukturen ein die Umschaltung des Thyristors aus dem blockierten Zustand in den stromführenden Zustand veranlassender Spannungsimpuls (P1) zugeführt wird.

7. Verfahren zum Betrieb eines Thyristors nach Anspruch 5, dadurch gekennzeichnet, daß ein an dem Anschluß (Z) für den Zündstromkreis (Z1) abgreifbarer Zündspannungsimpuls dem Steuerspannungsanschluß (G) der MIS-Strukturen als ein die Umschaltung des Thyristors aus dem blockierten Zustand in den stromführenden Zustand veranlassender Spannungsimpuls zugeführt wird.

## Claims

1. A thyristor having a semiconductor body which includes a first emitter layer (1a, 1b) located at the outside and provided with a first electrode (6, 7), a second emitter layer (4) located at the outside and provided with a second electrode (5), two base layers (2, 3) which respectively adjoin said first and second emitter layers, and an auxiliary emitter zone (H1, H2 ; H11-H14) located at the outside and which adjoins one of the base layers (2) and is provided with an auxiliary emitter electrode (8, 9 ; 23-26) which at its side facing the first emitter layer, is extended in such a manner that it bridges a PN-junction present at this side between the auxiliary emitter zone and a part of the adjoining base layer, characterised in that on a first bounding surface (F) of the semiconductor body which carries the auxiliary emitter electrode (8, 9), there is arranged at least one disconnectible current path formed as a MIS-structure (12, H1, 14, 15, 16) and which comprises a first semiconductor region (14) which is connected to the base layer (2) and lies at the first bounding surface (F), a second semiconductor region (12) which is arranged within the auxiliary emitter zone (H1, H2 ; H11, H14) and which is of the same conductivity type as the first semiconductor region, and an intermediate layer of the opposite conductivity type which is arranged between the two semiconductor regions and connected to the auxiliary emitter zone and is covered by a gate (16, 19) which is electrically insulated from the semiconductor body and provided with a control voltage terminal (G) ; and that the first emitter layer (1a, 1b) is penetrated by at least one zone (20, 21) of the adjoining base layer (2) which extends as far as the first bounding surface (F) of the semiconductor body and is conductively connected to the first electrode (6, 7) thereat.

2. A thyristor as claimed in Claim 1, characterised in that the auxiliary emitter zone is divided into a plurality of sub-zones (H11 to H14) which are respectively provided with parts (23 to 26) of the auxiliary emitter electrode which are conductively connected to one another ; and that a plurality of strip-shaped MIS-structures is provided arranged at the edges of the sub-zones (H11 to H14).

3. A thyristor as claimed in Claim 1 or Claim 2, characterised in that the first semiconductor regions (12, 13) of the MIS-structures are respectively inserted into the auxiliary emitter zone and into its sub-zones (H1, H2), in such a way that they extend as far as the first bounding surface (F) of the semiconductor body, at which surface they are conductively connected to the auxiliary emitter electrode and to its parts (8, 9), as the case may be ; that the second semiconductor regions of the MIS-structures respectively consist of parts (14) of the base layer (2) which adjoins the auxiliary emitter zone (H1, H2), which parts extend to the bounding surface (F) ; and that the intermediate layers respectively consist of the parts of the auxiliary emitter zone or its sub-zones (H1, H2) which are present between the mutually oppositely located bounding surfaces of the parts (14) of the adjoining base layer (2) and the first semiconductor regions (12, 13).

4. A thyristor as claimed in one of the preceding Claims, characterized in that a base layer or a zone thereof is provided with an ignition electrode (22) which has a terminal (Z) for an ignition circuit (Z1).

5. A thyristor as claimed in Claim 4, characterised in that the terminal (Z) for the ignition circuit is connected to the control voltage terminal (G) of the MIS-structures.

6. A process for the operation of a thyristor as claimed in Claim 1, characterised in that the control voltage terminal (G) of the MIS-structures is supplied with a voltage pulse (P1) which causes change-over of the thyristor from the blocked state to the current-carrying state.

7. A process for the operation of a thyristor as claimed in Claim 5, characterised in that an ignition voltage pulse, which can be tapped at the terminal (Z) for the ignition circuit (Z1), is supplied to the control voltage terminal (G) of the MIS-structures as a voltage pulse causing change-over of the thyristor from the blocked state into the current-carrying state.

**Revendications**

1. Thyristor comportant un corps semiconducteur, qui comprend une première couche d'émetteur (1a, 1b) se trouvant à l'extérieur et munie d'une première électrode (6, 7), une seconde couche d'émetteur (4) se trouvant à l'extérieur et munie d'une seconde électrode (5), deux couches de base (2, 3) respectivement contiguës à celle-ci, et une zone d'émetteur auxiliaire (H1, H2 ; H11-H14) se trouvant à l'extérieur, qui est contiguë à une des couches de base (2) et qui est munie d'une électrode d'émetteur auxiliaire (8, 9 ; 23-26), qui est prolongée du côté tourné vers la première couche d'émetteur de manière à shunter une jonction pn qui s'y trouve entre la zone d'émetteur auxiliaire et une partie de la couche de base contiguë, caractérisé par le fait qu'au niveau de la première surface limite (F) du corps semiconducteur qui porte l'électrode d'émetteur auxiliaire (8, 9) est disposé au moins un trajet de courant qui peut être mis hors circuit et qui se présente sous la forme d'une structure MIS (12, H1, 14, 15, 16), qui comprend un premier domaine semiconducteur (14) qui est contigu à la couche de base (2) se trouvant au niveau de la première surface limite (F), un second domaine semiconducteur (12) du même type de conductivité que le premier domaine semiconducteur et disposé à l'intérieur de la zone d'émetteur auxiliaire (H1, H2 ; H11-H14), et une couche intermédiaire, de type de conductivité opposé, contiguë à la zone d'émetteur auxiliaire et se trouvant entre ces deux domaines semiconducteurs, qui est recouverte par une porte (16, 19) munie d'une borne de tension de commande (G) et isolée du point de vue électrique vis-à-vis du corps semiconducteur, et que la première couche d'émetteur (1a, 1b) est traversée par au moins une zone (20, 21) de la couche de base contiguë (2), qui s'étend jusqu'à la première surface limite (F) du corps semiconducteur et qui est reliée de façon conductrice dans celle-ci à la première électrode (6, 7).

2. Thyristor suivant la revendication 1, caractérisé par le fait que la zone d'émetteur auxiliaire est subdivisée en un grand nombre de zones partielles (H11 à H14) qui sont respectivement munies de parties (23 à 26) de l'électrode d'émetteur auxiliaire qui sont réunies de façon conductrice entre elles, et que sont prévues un grand nombre de structures MIS sous forme de bandes qui sont disposées latéralement par rapport aux zones partielles (H1 à H14).

3. Thyristor suivant l'une des revendications 1 ou 2, caractérisé par le fait que les premiers domaines semiconducteurs (12, 13) des structures MIS sont respectivement insérés dans la zone d'émetteur auxiliaire ou dans ses zones partielles (H1, H2) de manière à s'étendre jusqu'à la première surface limite (F) du corps semiconducteur, dans laquelle elles sont réunies de façon conductrice à l'électrode d'émetteur auxiliaire, ou à ses parties (8, 9), que les seconds domaines semiconducteurs des structures MIS sont respectivement constitués par des parties (14) de la couche de base (2) contiguës à la zone d'émetteur auxiliaire (H1, H2), qui s'étendent jusqu'à la surface limite (F), et que les couches intermédiaires sont respectivement constituées par les parties de la zone d'émetteur auxiliaire ou de ses zones partielles (H1, H2), qui se trouvent entre les surfaces limites se faisant face des parties (14) de la couche de base (2) contiguë et des premiers domaines semiconducteurs (12, 13).

4. Thyristor suivant l'une des revendications précédentes, caractérisé par le fait qu'une couche de base ou une zone de celle-ci est munie d'une électrode d'amorçage (22) qui comporte une borne (Z) pour un circuit de courant d'amorçage (Z1).

5. Thyristor suivant la revendication 4, caractérisé par le fait que la borne (Z) pour le circuit de courant d'amorçage est reliée à la borne de tension de commande (G) des structures MIS.

6. Procédé pour la mise en service d'un thyristor suivant la revendication 1, caractérisé par le fait qu'à la borne de tension de commande (G) des structures MIS est appliquée une impulsion de tension (P1) provoquant la commutation du thyristor de l'état bloqué dans l'état conducteur.

7. Procédé pour la mise en service d'un thyristor suivant la revendication 5, caractérisé par le fait qu'une impulsion de tension d'amorçage, pouvant être prélevée sur la borne (Z) pour le circuit de courant d'amorçage (Z1) est appliquée à la borne de tension de commande (G) des structures MIS, en tant qu'impulsion de tension provoquant la commutation du thyristor de l'état bloqué dans l'état conducteur.

FIG 1

FIG 2

# FIG 3